# EUROPEAN PATENT APPLICATION

(11) **EP 4 823 279 A1**
(43) Date of publication of application: **14.10.2026**
(21) Application number: 24900569.5
(22) Date of filing: 02.12.2024
(51) Int. Cl.: H10F 39/12

(54) **SEMICONDUCTOR DEVICE, SEMICONDUCTOR DEVICE MANUFACTURING METHOD, PHOTOELECTRIC CONVERSION SYSTEM, AND MOBILE BODY**

(30) Priority: 04.12.2023 JP 2023204913
(71) Applicant: Canon Kabushiki Kaisha, Tokyo 146-8501 (JP)
(72) Inventor: YOSHIDA, Ryo, Tokyo 146-8501 (JP)
(74) Representative: TBK
(86) International application number: PCT/JP2024/042489
(87) International publication number: WO 2025/121275

(57) **Abstract**

A semiconductor device has a structure in which a plurality of semiconductor layers including a first semiconductor layer, a second semiconductor layer, and a third semiconductor layer and an insulating structure insulating the plurality of semiconductor layers from each other are stacked, the insulating structure including a first insulating layer arranged between the first semiconductor layer and the second semiconductor layer, and the second insulating layer between the second semiconductor layer and the third semiconductor layer. The semiconductor device includes a conductive through via extending through the second semiconductor layer; a wiring pattern arranged in the first insulating layer; and a conductive connecting member arranged in the first insulating layer to electrically connect the through via and the wiring pattern.

## Description

### TECHNICAL FIELD

The present invention relates to a semiconductor device, a manufacturing method of the semiconductor device, a photoelectric conversion system, and a moving body.

### BACKGROUND ART

PTL 1 describes a step of forming a structure which includes a silicon substrate and a wiring layer, then forming a through hole which extends through the silicon substrate and reaches an electrode in the wiring layer, forming an insulating film on the side surface of the through hole, and finally forming a through via in the through hole. However, in a case where a thin deep through hole is required, it is difficult to form the through hole by etching. In addition, in a case of forming a through hole which reaches an electrode or a wiring pattern, etching damage to the electrode or the wiring pattern can decrease reliability.

### CITATION LIST

### PATENT LITERATURE

PTL 1: Japanese Patent Laid-Open No. 2016-171297

### SUMMARY OF INVENTION

One aspect of the present invention provides a semiconductor device having a structure that is easy to manufacture and has excellent reliability.

One aspect of the present invention relates to a semiconductor device that has a structure in which a plurality of semiconductor layers including a first semiconductor layer, a second semiconductor layer, and a third semiconductor layer and an insulating structure insulating the plurality of semiconductor layers from each other are stacked, the insulating structure including a first insulating layer arranged between the first semiconductor layer and the second semiconductor layer, and the second insulating layer between the second semiconductor layer and the third semiconductor layer, and the semiconductor device comprises a conductive through via extending through the second semiconductor layer, a wiring pattern arranged in the first insulating layer, and a conductive connecting member arranged in the first insulating layer to electrically connect the through via and the wiring pattern.

Other features and advantages of the present invention will be apparent from the following description taken in conjunction with the accompanying drawings. Note that the same reference numerals denote the same or like components throughout the accompanying drawings.

### BRIEF DESCRIPTION OF DRAWINGS

Fig. 1 is a view showing the basic arrangement of a photoelectric conversion device according to an embodiment;
Fig. 2 is a view showing an example of the arrangement of a sensor substrate;
Fig. 3 is a view showing an example of the arrangement of the first circuit substrate;
Fig. 4 is a view showing an example of the arrangement of the second circuit substrate;
Fig. 5 is a view exemplarily showing an equivalent circuit of one pixel that can be constituted by one photoelectric conversion element, one first signal processing unit, and one second signal processing circuit;
Fig. 6A is a view schematically showing a relationship between an operation of an APD and an output signal;
Fig. 6B is a view schematically showing the relationship between the operation of the APD and the output signal;
Fig. 7 is a sectional view schematically showing the sectional structure of a photoelectric conversion device as a semiconductor device according to the first embodiment;
Fig. 8 is an enlarged schematic view of the arrangement in a connection portion between a through via and a connecting member in Fig. 7;
Fig. 9 is an enlarged schematic view of a modification of the arrangement in the connection portion between the through via and the connecting member in Fig. 7;
Fig. 10 is a sectional view schematically showing the sectional structure of a photoelectric conversion device as a semiconductor device according to the first modification;
Fig. 11A is a plan view schematically showing the arrangement of the photoelectric conversion device according to the embodiment;
Fig. 11B is a schematic sectional view taken along a line B - B' in Fig. 11A;
Fig. 12A is a sectional view schematically showing a manufacturing method of the photoelectric conversion device according to the first embodiment;
Fig. 12B is a sectional view schematically showing the manufacturing method of the photoelectric conversion device according to the first embodiment;
Fig. 12C is a sectional view schematically showing the manufacturing method of the photoelectric conversion device according to the first embodiment;
Fig. 13 is a sectional view schematically showing the sectional structure of a photoelectric conversion device as a semiconductor device according to the second modification;
Fig. 14 is a sectional view schematically showing the sectional structure of a photoelectric conversion device as a semiconductor device according to the second modification;
Fig. 15 is a sectional view schematically showing the sectional structure of a photoelectric conversion device as a semiconductor device according to the third modification;
Fig. 16A is a sectional view schematically showing a manufacturing method of the photoelectric conversion device as the semiconductor device according to the second modification;
Fig. 16B is a sectional view schematically showing the manufacturing method for the semiconductor device according to the second modification;
Fig. 16C is a sectional view schematically showing the manufacturing method for the semiconductor device according to the second modification;
Fig. 17 is a view showing the arrangement of a photoelectric conversion system according to the second embodiment;
Fig. 18A is a view showing the arrangement of a photoelectric conversion system and a moving body according to the third embodiment;
Fig. 18B is a view showing the arrangement of the photoelectric conversion system and the moving body according to the third embodiment;
Fig. 19 is a view showing the arrangement of a photoelectric conversion system according to the fourth embodiment;
Fig. 20 is a view showing the arrangement of an endoscopic surgery system as a photoelectric conversion system according to the fifth embodiment;
Fig. 21A is a view showing the arrangement of a photoelectric conversion system according to the sixth embodiment;
Fig. 21B is a view showing the arrangement of a photoelectric conversion system according to the sixth embodiment;
Fig. 22A is a view showing the arrangement of a photoelectric conversion system according to the seventh embodiment;
Fig. 22B is a view showing the arrangement of a photoelectric conversion system according to the seventh embodiment; and
Fig. 23 is a view showing the arrangement of an X-ray CT apparatus as a photoelectric conversion system according to the eighth embodiment.

### DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

Embodiments of the present invention will be described in detail below based on the accompanying drawings. Note that in the following description, terms (for example, "upper", "lower", "right", "left" and other terms including these terms) representing specific directions or positions are used, as necessary. These terms are used for easy understanding of the embodiments with reference to the accompanying drawings, and the meanings of the terms do not limit the technical scope of the present invention.

In this specification, a plan view corresponds to viewing a semiconductor device from a direction perpendicular to the main surface (one surface, and preferably the flatter surface of two largest surfaces) of one semiconductor layer, and is synonymous with orthogonal projection to the main surface. A sectional view corresponds to a plane in the direction perpendicular to the main surface. Note that if the main surface is rough microscopically, the plan view is defined with reference to the main surface viewed macroscopically.

**In** exemplary embodiments to be described below, a semiconductor device configured as a photoelectric conversion device that includes an avalanche photodiode (to be also referred to as an APD hereinafter) as a photoelectric conversion element will be described. However, the semiconductor device may be configured as a semiconductor device without a photoelectric conversion function.

**In** the following description of exemplary embodiments, the anode of an avalanche photodiode is set to a fixed potential, and a signal is extracted from the cathode side. Therefore, a semiconductor region of the first conductivity type containing, as a majority carrier, a charge with the same first polarity as that of a signal charge is an n-type semiconductor region, and a semiconductor region of the second conductivity type containing, as a majority carrier, a charge with the second polarity different from that of the signal charge is a p-type semiconductor region. Note that even if the cathode of the APD is set to a fixed potential and a signal is extracted from the anode side, the present invention is viable. **In** this case, a semiconductor region of the first conductivity type containing, as a majority carrier, a charge with the same first polarity as that of a signal charge is a p-type semiconductor region, and a semiconductor region of the second conductivity type containing, as a majority carrier, a charge with the second polarity different from that of the signal charge is an n-type semiconductor region. A case in which one node of the APD is set to a fixed potential will be described below but the potentials of both the nodes may be variable.

In this specification, if a term "impurity concentration" is simply used, this indicates a net impurity concentration obtained by subtracting an impurity concentration compensated by impurities of an opposite conductivity type. That is, the "impurity concentration" indicates a net doping concentration. A region where the concentration of the added p-type impurities is higher than the concentration of the added n-type impurities is a p-type semiconductor region. To the contrary, a region where the concentration of the added n-type impurities is higher than the concentration of the added p-type impurities is an n-type semiconductor region.

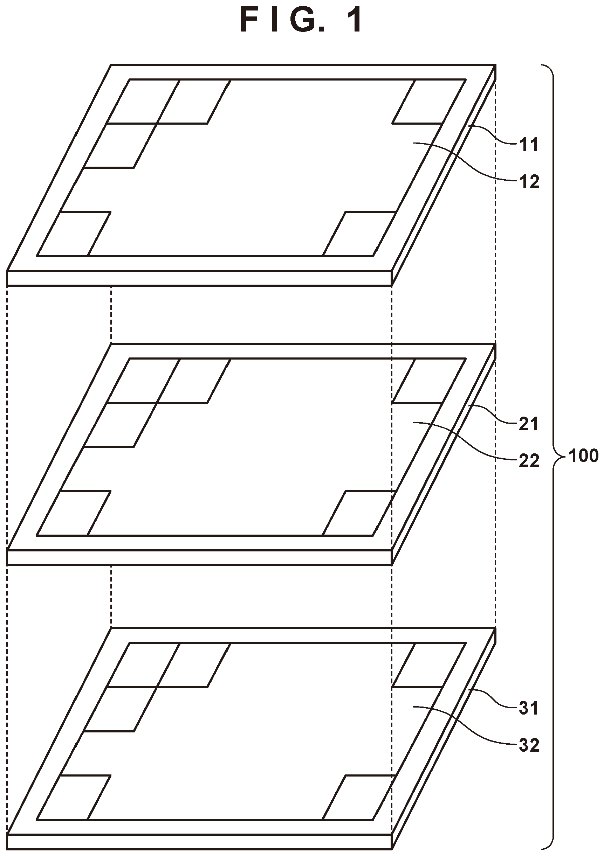

First of all, the basic arrangement and driving method common to photoelectric conversion devices and driving methods therefor according to a plurality of embodiments to be described later will be described with reference to Figs. 1, 2, 3, 4, 5, 6A, and 6B.

Fig. 1 is a view showing the basic arrangement of a photoelectric conversion device 100 according to an embodiment. An example in which the photoelectric conversion device 100 is formed as a stacked photoelectric conversion device will be described here. The photoelectric conversion device 100 can be formed by, for example, stacking a plurality of substrates including a sensor substrate 11, a first circuit substrate 21, and a second circuit substrate 31, and electrically connecting the plurality of substrates. The sensor substrate 11 can include a pixel array region 12 in which a plurality of photoelectric conversion elements 102 (to be described later) are arranged. The sensor substrate 11 can also include the first semiconductor layer including the photoelectric conversion elements 102 (to be described later), and the first wiring structure. The first circuit substrate 21 can include a first circuit region 22 where circuits such as first signal processing units 103A (to be described later) are arranged. The first circuit substrate 21 can also include the second semiconductor layer where a plurality of elements (for example, transistors) constituting circuits such as the first signal processing unit 103A (to be described later) are arranged, and the second wiring structure. The second circuit substrate 31 can include a second circuit region 32 where circuits including second signal processing units 103B (to be described later), a vertical scanning circuit 110, a horizontal scanning circuit 111, and a readout circuit 112 are arranged. The second circuit substrate 31 can also include the second semiconductor layer where a plurality of elements (for example, transistors) constituting circuits such as the second signal processing unit 103B (to be described later) are arranged, and the second wiring structure. The photoelectric conversion device to be described in each of the following embodiments can be, for example, a back-side illumination photoelectric conversion device, but the photoelectric conversion device according to the present invention may be formed as a front-side illumination photoelectric conversion device.

Each of the sensor substrate 11, the first circuit substrate 21, and the second circuit substrate 31 can be a chip diced from a wafer, but is not limited to the chip. For example, each substrate may be a wafer. The plurality of substrates may be obtained by stacking wafers and dicing them, or by forming chips and stacking or joining the plurality of chips.

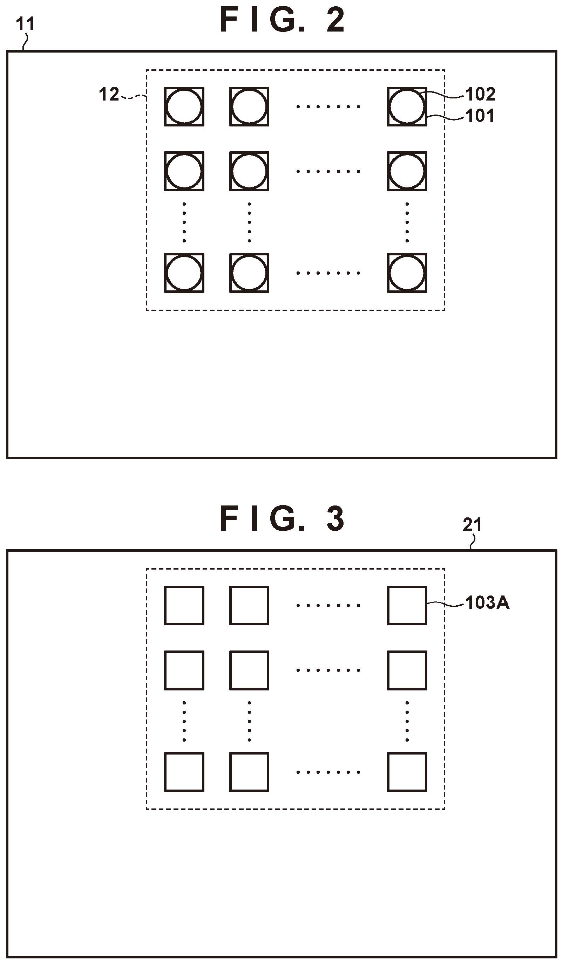

Fig. 2 is a view showing an example of the arrangement of the sensor substrate 11. In the pixel array region 12, a plurality of photoelectric conversion elements 102 can be arranged in a two-dimensional array to form a plurality of rows and a plurality of columns. Each photoelectric conversion element 102 can include an avalanche photodiode (APD). Each photoelectric conversion element 102 constitutes a part of a pixel 101.

Each pixel 101 arranged in the pixel array region 12 can be a pixel for forming an image. However, if the sensor substrate 11 or the photoelectric conversion device 100 is applied to Time of Flight (TOF), each pixel 101 need not always be a pixel for forming an image. That is, each pixel 101 may be a pixel for measuring the time at which light reaches and the amount of light.

Fig. 3 is a view showing an example of the arrangement of the first circuit substrate 21. The first circuit substrate 21 can include, for example, the first signal processing units 103A each configured to process a signal (electrical signal) generated according to charges (signal charges) generated by photoelectric conversion in the photoelectric conversion element 102. The first signal processing unit 103A can include, for example, a quenching element 202 (to be described later) and a waveform shaping unit 210 (to be described later) of each pixel 101.

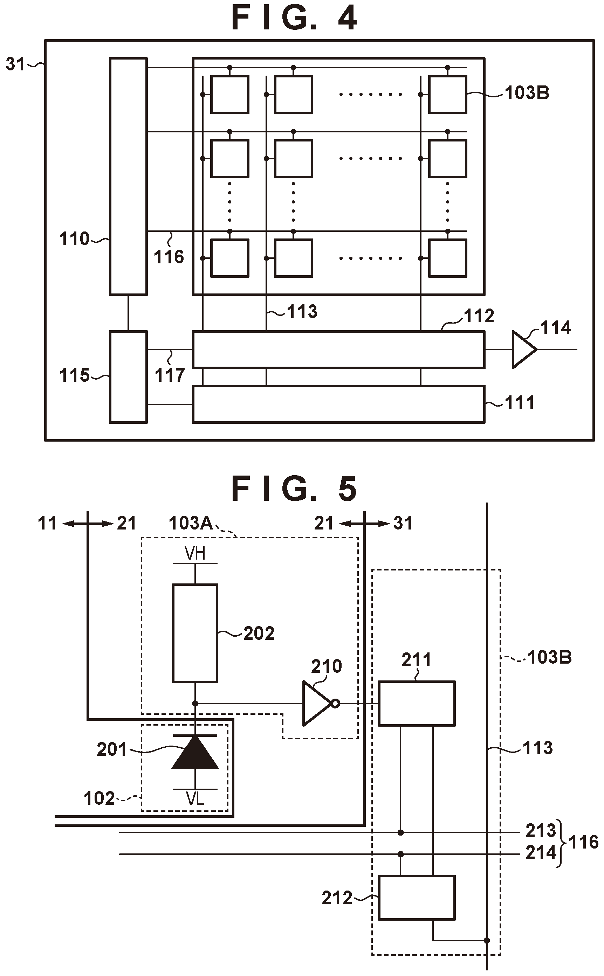

Fig. 4 is a view showing an example of the arrangement of the second circuit substrate 31. The second circuit substrate 31 can include the second signal processing units 103B, the readout circuit 112, a control pulse generation unit 115, the horizontal scanning circuit 111, signal lines 113 and 116, the vertical scanning circuit 110, and an output circuit 114. The second signal processing unit 103B can include, for example, in addition to a counter circuit 211 (to be described later) and a selection circuit 212 (to be described later) of each pixel 101, a plurality of signal lines 113 and a plurality of driving lines 116 arranged along the pixel array region 12, and the like. For example, the vertical scanning circuit 110 can be configured to generate a second control pulse by receiving a first control pulse supplied from the control pulse generation unit 115, and supply the second control pulse to each pixel 101. The vertical scanning circuit 110 can include, for example, a logical circuit such as a shift register and an address decoder. A signal output from the photoelectric conversion element 102 of each pixel 101 can be processed by the signal processing unit 103 provided in correspondence with the pixel 101. The signal processing unit 103 can include a counter with a memory. The horizontal scanning circuit 111 can be configured to supply, to the signal processing unit 103, the third control pulse for sequentially selecting columns to read out a signal from the counter (memory) of each pixel 101 that holds a digital signal. Signals are output, to the plurality of signal lines 113, from the second signal processing units 103B assigned to the pixels 101 of the row selected by the vertical scanning circuit 110. The signals output to the plurality of signal lines 113 can be output, via the output circuit 114, to a recording unit or a signal processing unit outside the photoelectric conversion device 100.

In Fig. 2, the array of the photoelectric conversion elements 102 or the pixels 101 in the pixel array region 12 may be a one-dimensional array. A set of signal processing units 103A and 103B may be assigned to at least two photoelectric conversion elements 102 or pixels 101.

As shown in Figs. 2, 3, and 4, the plurality of first signal processing units 103A and the plurality of second signal processing units 103B can be arranged in a region overlapping the pixel array region 12 in a plan view. Then, the vertical scanning circuit 110, the horizontal scanning circuit 111, the readout circuit 112, the output circuit 114, and the control pulse generation unit 115 can be arranged to overlap the region between the outer edge of the sensor substrate 11 and the outer edge of the pixel array region 12 in a plan view. In other words, the vertical scanning circuit 110, the horizontal scanning circuit 111, the readout circuit 112, the output circuit 114, and the control pulse generation unit 115 can be arranged in a region overlapping the peripheral region of the sensor substrate 11 in a plan view.

Fig. 5 exemplarily shows an equivalent circuit of one pixel 101 that can be constituted by one photoelectric conversion element 102, one first signal processing unit 103A, and one second signal processing circuit 103B. The photoelectric conversion element 102 includes an APD 201, and the APD 201 generates charge pairs corresponding to incident light by photoelectric conversion. The anode of the APD 201 is supplied with a voltage VL (first voltage). The cathode of the APD 201 can be supplied with a voltage VH (second voltage) higher than the voltage VL supplied to the anode. A reverse bias voltage (predetermined voltage) that can cause the APD 201 to perform an avalanche multiplication operation can be supplied between the anode and the cathode. By setting the state in which such reverse bias voltage is supplied between the anode and the cathode, charges generated by the incident light cause an avalanche multiplication operation, thereby generating an avalanche current.

A mode of operating an APD in a state in which the voltage between the anode and the cathode is higher than the breakdown voltage is called a Geiger mode. A mode of operating an APD in a state in which the voltage between the anode and the cathode is around or lower than the breakdown voltage is called a linear mode. An APD operated in the Geiger mode is called an SPAD. For example, the voltage VL (first voltage) is -30 V and the voltage VH (second voltage) is 1 V. The APD 201 may be operated in either the linear mode or the Geiger mode.

The first signal processing unit 103A can include the quenching element 202 and the waveform shaping unit 210. The quenching element 202 can be arranged to connect the APD 201 and a power supply for supplying the voltage VH. The quenching element 202 functions as a load circuit (quenching circuit) at the time of signal multiplication by an avalanche multiplication operation, and serves to suppress avalanche multiplication by suppressing the voltage supplied to the APD 201 (quenching operation). In addition, the quenching element 202 serves to return, to the voltage VH, the voltage supplied to the APD 201 by sending a current corresponding to a voltage drop caused by a quenching operation (recharging operation). The waveform shaping unit 210 can output a pulse signal by shaping the potential change of the cathode of the APD 201 obtained at the time of detection of a photon. As the waveform shaping unit 210, for example, an inverter circuit can be used. In Fig. 5, the waveform shaping unit 210 is formed by one inverter but the waveform shaping unit 210 may include a plurality of serially connected inverters or include another circuit having the waveform shaping effect.

The second signal processing unit 103B can include the counter circuit 211 and the selection circuit 212. The counter circuit 211 can count a pulse signal output from the waveform shaping unit 210, and hold a count value. The counter circuit 211 can be configured to reset the signal held in the counter circuit 211 when a control pulse pRES is supplied via a driving line 213. The selection circuit 212 can be supplied with a control pulse pSEL from the vertical scanning circuit 110 via a driving line 214, thereby switching between electrical connection and non-connection of the counter circuit 211 and the signal line 113. The selection circuit 212 can include, for example, a buffer circuit for outputting a signal.

A switch such as a transistor may be arranged between the quenching element 202 and the APD 201 and/or between the APD 201 and the waveform shaping unit 210, thereby controlling electrical connection by the switch. Similarly, a switch such as a transistor may control supply of the voltage VH and/or the voltage VL to the APD 201.

The photoelectric conversion device 100 may be configured to acquire a pulse detection timing using a Time to Digital Converter (to be referred to as a TDC hereinafter) and a memory, instead of the counter circuit 211. The generation timing of the pulse signal output from the waveform shaping unit 210 can be converted into a digital signal by the TDC. A control pulse pREF (reference signal) can be supplied from the vertical scanning circuit 110 to the TDC via a driving line to measure the timing of the pulse signal. The TDC can acquire, as a digital signal, a signal obtained when the input timing of the signal output from each pixel via the waveform shaping unit 210 is set as the relative time with reference to the control pulse pREF.

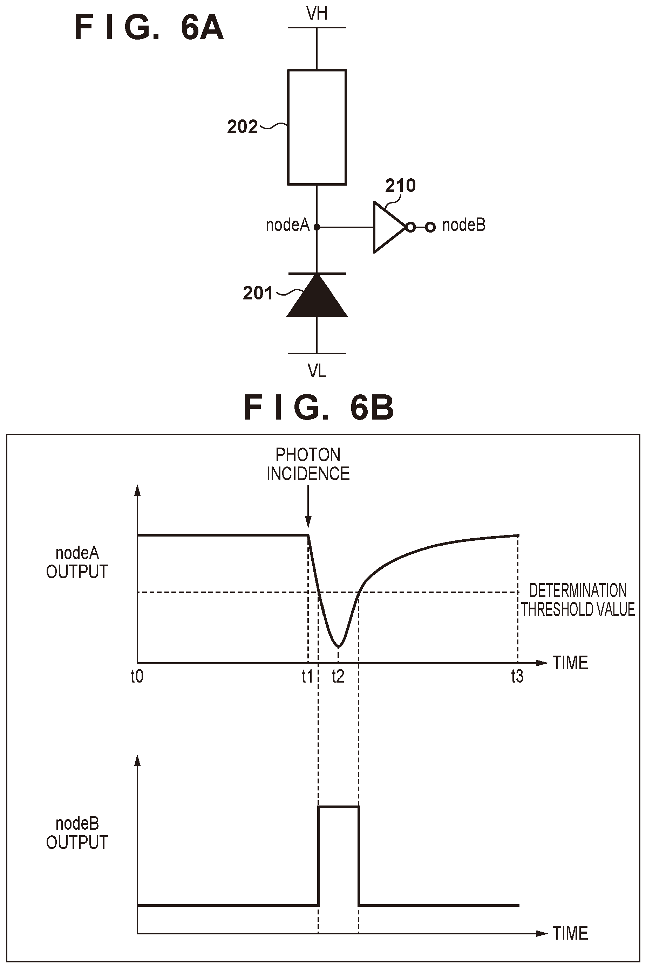

Fig. 6B is a view schematically showing a relationship between an operation of the APD 201 and an output signal. Fig. 6A is a view showing the APD 201, the quenching element 202, and the waveform shaping unit 210 shown in Fig. 5. The input side of the waveform shaping unit 210 is indicated by node A and the output side of the waveform shaping unit 210 is indicated by node B. Fig. 6B shows the waveform change of node A and the waveform change of node B shown in Fig. 6A.

During a period from time t0 to time t1, a potential difference of VH - VL is applied to the APD 201 shown in Fig. 6A. When a photon enters the APD 201 at time t1, the APD 201 performs an avalanche multiplication operation, and an avalanche multiplication current flows through the quenching element 202, thereby dropping the voltage of node A. When the voltage drop amount further increases and the potential difference applied to the APD 201 decreases, the avalanche multiplication operation of the APD 201 stops at time t2, and the voltage level of node A does not drop any more from a predetermined value. After that, a current that compensates for the voltage drop from the voltage VL flows through node A during a period from time t2 to time t3, and node A is settled at the original potential level at time t3. At this time, a portion of the output waveform of node A, which exceeds a given threshold, is waveform-shaped by the waveform shaping unit 210, and output as a signal from node B.

Note that the arrangement of the signal lines 113 and the arrangement of the readout circuit 112 and the output circuit 114 are not limited to the arrangement exemplarily shown in Fig. 4. For example, the signal lines 113 may be extended in the row direction, and the readout circuit 112 may be arranged at a position to which the signal lines 113 are extended.

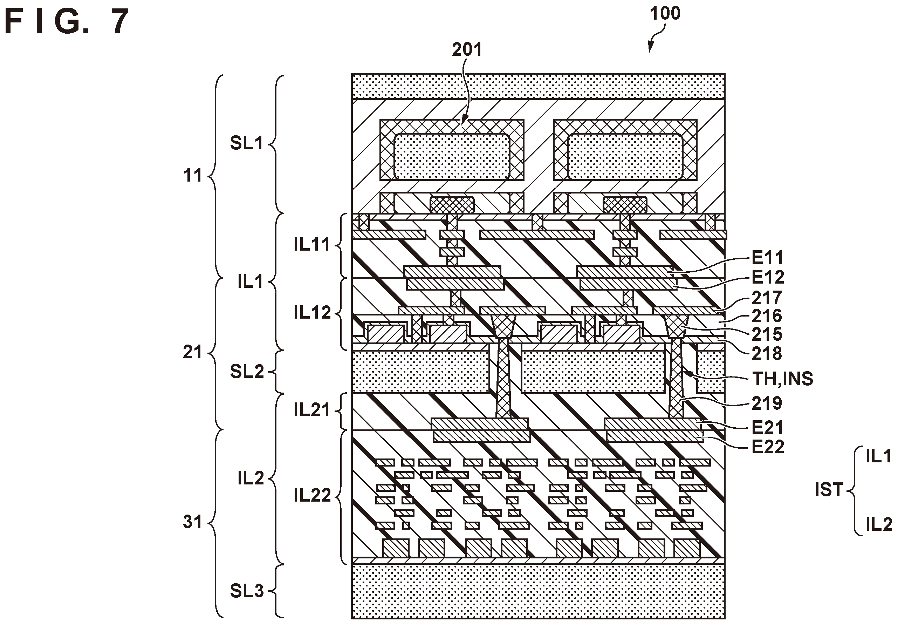

Fig. 7 schematically shows the sectional structure of a photoelectric conversion device 100 as a semiconductor device according to the first embodiment. The photoelectric conversion device 100 can have a structure in which a plurality of semiconductor layers including a first semiconductor layer SL1 and a second semiconductor layer SL2 and an insulating structure IST insulating the plurality of semiconductor layers from each other are stacked. The insulating structure IST can include a first insulating layer IL1 arranged between the first semiconductor layer SL1 and the second semiconductor layer SL2. The insulating structure IST can further include a second insulating layer IL2. The second semiconductor layer SL2 can be arranged between the first insulating layer IL1 and the second insulating layer IL2. The plurality of the semiconductor layers may further include a third semiconductor layer SL3, and the second insulating layer IL2 can be arranged between the second semiconductor layer SL2 and the third semiconductor layer SL3.

In another aspect, the photoelectric conversion device 100 can include a conductive through via 219 extending through the second semiconductor layer SL2, and a wiring pattern 217 arranged in the insulating structure IST. The photoelectric conversion device 100 can also include a conductive connecting member 215 arranged in the insulating structure IST to electrically connect the through via 219 and the wiring pattern 217.

The first insulating layer IL1 can include an insulating layer IL11 and an insulating layer IL12 joined to each other. The second insulating layer IL2 can include an insulating layer IL21 and an insulating layer IL22 joined to each other. The first semiconductor layer SL1 and the insulating layer IL11 can constitute the sensor substrate 11. The second semiconductor layer SL2 and the insulating layers IL12 and IL21 can constitute the first circuit substrate 21. The third semiconductor layer SL3 and the insulating layer IL22 can constitute the second circuit substrate 31. A junction electrode E11 is arranged in the insulating layer IL11, and a junction electrode E12 is arranged in the insulating layer IL12. The junction electrode E11 and the junction electrode E12 can form a metal joint surface. A junction electrode E21 is arranged in the insulating layer IL21, and a junction electrode E22 is arranged in the insulating layer IL22. The junction electrode E21 and the junction electrode E22 can form a metal joint surface.

The photoelectric conversion device 100 or the first circuit substrate 21 can include the conductive through via 219 extending through the second semiconductor layer SL2. The through via 219 can be formed of, for example, tungsten, but may be formed of another material such as aluminum or copper. The through via 219 can be arranged to extend through an insulator INS arranged in a through hole TH in the second semiconductor layer SL2. The photoelectric conversion device 100 or the first circuit substrate 21 can include the wiring pattern 217 arranged in the first insulating layer IL1 (insulating layer IL12). The wiring pattern 217 is formed of, for example, copper or aluminum, but may be formed of another material. The photoelectric conversion device 100 or the first circuit substrate 21 can include the conductive connecting member 215 arranged in the first insulating layer IL1 (insulating layer IL12) to electrically connect the through via 219 and the wiring pattern 217. The connecting member 215 can be formed of, for example, tungsten, but may be formed of another material such as aluminum or copper. The connecting member 215 can be, for example, a plug.

According to the arrangement in which the through via 219 is electrically connected to the wiring pattern 217 via the connecting member 215, it is possible to decrease the height of the through via 219, in other words, to decrease the depth of the through hole for forming the through via 219. This is advantageous for stably forming the fine through via 219. This structure is also advantageous in that, when forming the through hole for forming the through via 219 by etching, there is no etching damage to the wiring pattern 217.

If the wiring pattern 217 contains copper, it is advantageous to form the connecting member 215 from a material containing no copper, and stop a dry etching step of forming the through hole for the through via 219 at the connecting member 215. This is because, if etching is stopped at the wiring pattern 217 containing copper, the wiring pattern 217 containing copper is exposed to the etching environment for a long time, which can cause a problem. More specifically, since a copper-containing material, which can be generated when the wiring pattern 217 containing copper is exposed to the etching environment, is nonvolatile, it accumulates in a chamber rather than being exhausted from the chamber, and can react with various gases. Therefore, the copper-containing material accumulated in the chamber can cause fluctuation of the etching rate of a dry etching apparatus, that is, can destabilize the process.

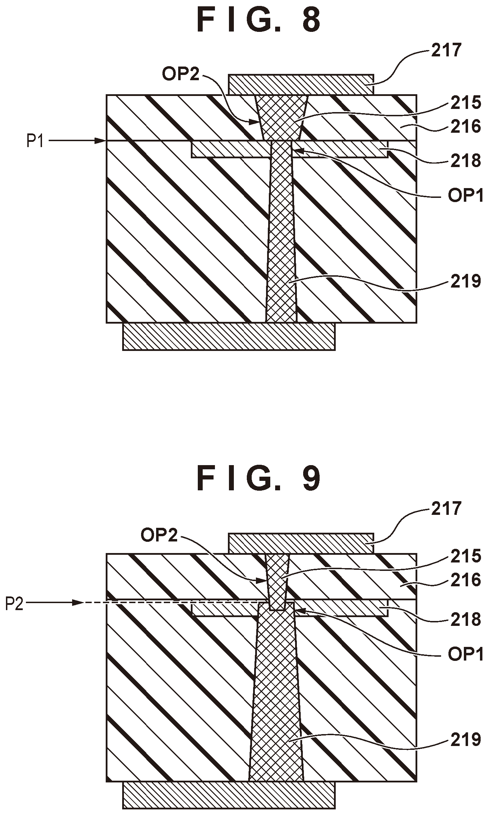

Fig. 8 shows an enlarged schematic view of the arrangement in the connection portion between the through via 219 and the connecting member 215 in Fig. 7. As schematically shown in Fig. 8, in the connection portion between the through via 219 and the connecting member 215, the width of the connecting member 215 can be larger than the width of the through via 219. More specifically, the width of the connecting member 215 at a plane P1 including an interface between the through via 219 and the connecting member 215 can be larger than the width of the through via 219 at the plane P1. This can relax requirements for alignment accuracy of the through via 219 with respect to the connecting member 215.

Fig. 9 shows an enlarged schematic view of a modification of the arrangement in the connection portion between the through via 219 and the connecting member 215 in Fig. 7. As schematically shown in Fig. 9, the width of the through via 219 in the connection portion between the through via 219 and the connecting member 215 can be larger than the width of the connecting member 215. More specifically, the width of the through via 219 at a plane P2 including an end face (an end face on the connecting member 215 side) of the through via 219 can be larger than the width of the connecting member 215 at the plane P2. This can relax requirements for alignment accuracy of the through via 219 with respect to the connecting member 215.

As schematically shown in Figs. 7, 8, and 9, in the connection portion between the connecting member 215 and the wiring pattern 217, the width of the wiring pattern 217 is preferably larger than the width of the connecting member 215. This can relax requirements for alignment accuracy between the connecting member 215 and the wiring pattern 217. To the contrary, in the connection portion between the connecting member 215 and the wiring pattern 217, the width of the connecting member 215 may be larger than the width of the wiring pattern 217. This can also relax requirements for alignment accuracy between the connecting member 215 and the wiring pattern 217.

As schematically shown in Figs. 7, 8, and 9, the insulating structure IST can include a first film 218 including a first opening OP1, and a second film 216 arranged to overlap the first film 218 and including a second opening OP2. The through via 219 can include a portion arranged in the first opening OP1, and the connecting member 215 can be arranged in the second opening OP2.

The through via 219 can have a tapered shape with the width decreasing toward the connecting member 215. The connecting member 215 can have a tapered shape with the width decreasing toward the through via 219. The through hole TH in the second semiconductor layer SL2 can have, for example, a tapered shape with the width increasing toward the first semiconductor layer SL1, but conversely, it may have a tapered shape with the width decreasing toward the first semiconductor layer SL1.

The thickness of the second semiconductor layer SL2 is preferably smaller than the thickness of each semiconductor layer of the plurality of semiconductor layers other than the second semiconductor layer SL. For example, the thickness of the second semiconductor layer SL2 is preferably smaller than the thickness of each of the first semiconductor layer SL1 and the third semiconductor layer SL3. This is advantageous for decreasing the height of the through via 219.

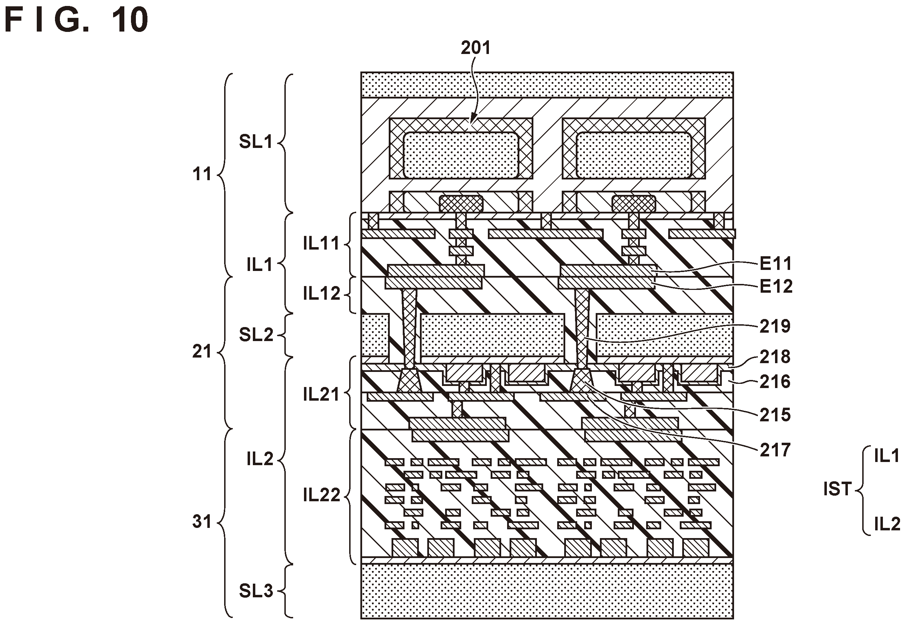

Fig. 10 schematically shows the sectional structure of the photoelectric conversion device 100 as the semiconductor device according to the first modification. Matters not mentioned with respect to the first modification can follow the first embodiment schematically shown in Fig. 7, unless they contradict each other. In the first modification as well, the photoelectric conversion device 100 can include the conductive through via 219 extending through the second semiconductor layer SL2, and the wiring pattern 217 arranged in the insulating structure IST. The photoelectric conversion device 100 can also include the conductive connecting member 215 arranged in the insulating structure IST to electrically connect the through via 219 and the wiring pattern 217. The through via 219 can be arranged to connect the junction electrode E12 and the connecting member 215. From another viewpoint, the through via 219 can be arranged to contact the junction electrode E12 and the connecting member 215. The through via 219 can have a tapered shape with the width decreasing toward the connecting member 215. The connecting member 215 can have a tapered shape with the width decreasing toward the through via 219.

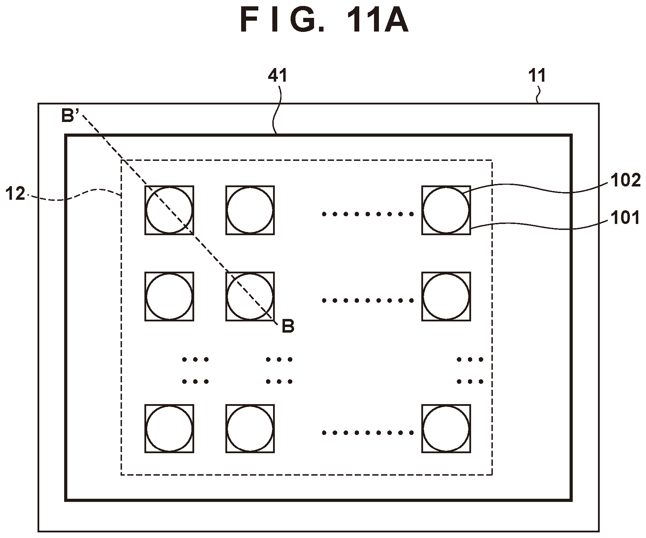

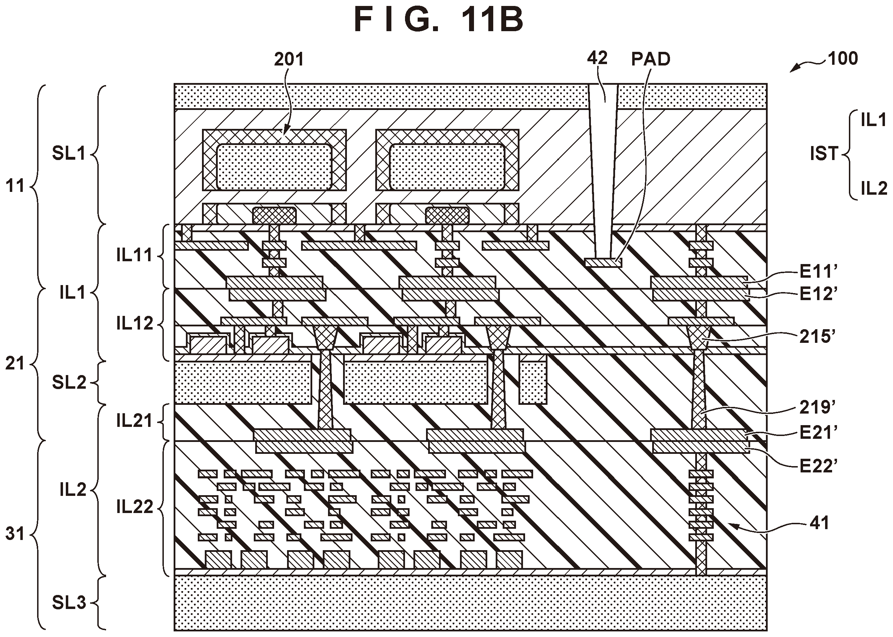

Fig. 11A is a schematic plan view showing the arrangement of the photoelectric conversion device 100 according to the embodiment, and Fig. 11B is a schematic sectional view taken along a line B - B' in Fig. 11A. With reference to Figs. 11A and 11B, the arrangement of a peripheral portion in the photoelectric conversion device 100 will be exemplarily described. The photoelectric conversion device 100 can include a guard ring 41 arranged between the pixel array region 12 and an edge EP. The guard ring 41 can include a through via 219' and a connecting member 215' that can have a sectional structure similar to that of the through via 219 and the connecting member 215. The guard ring 41 can also include junction portions E11', E12', 21', and E21' that can have a sectional structure similar to that of the junction electrodes E11, E12, 21, and E21. The photoelectric conversion device 100 can include a pad PAD arranged between the guard ring 41 and the pixel array region, and a pad opening 42 for exposing the pad PAD.

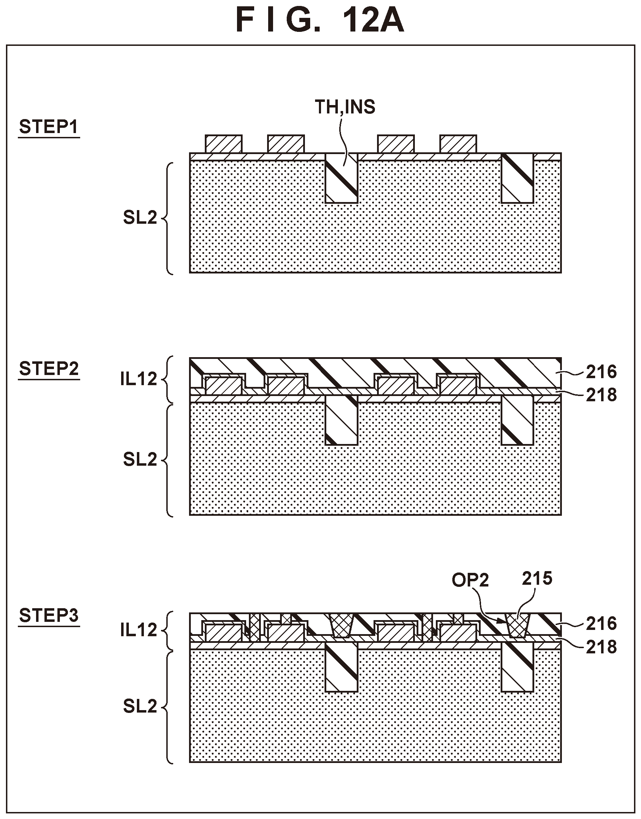

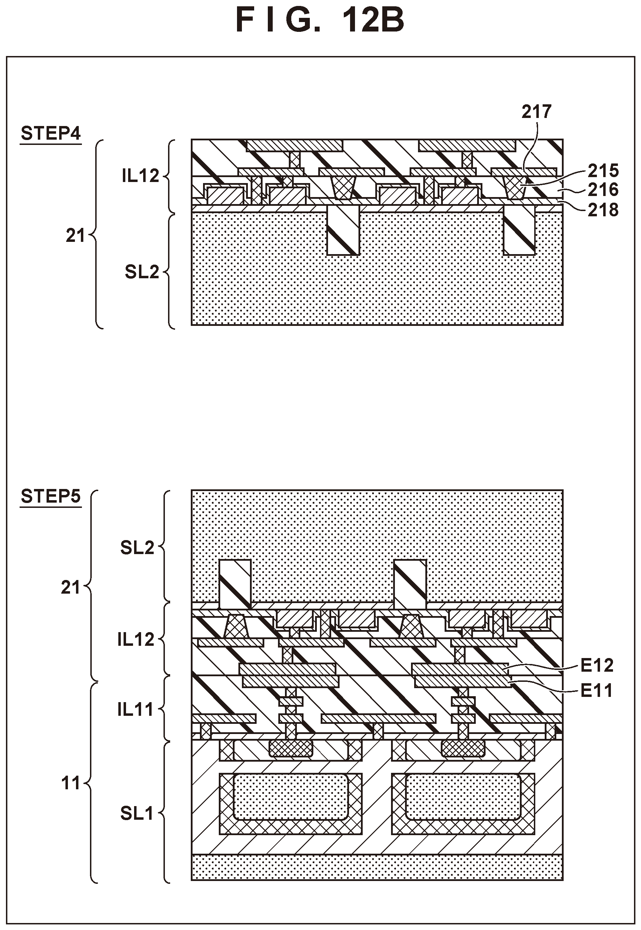

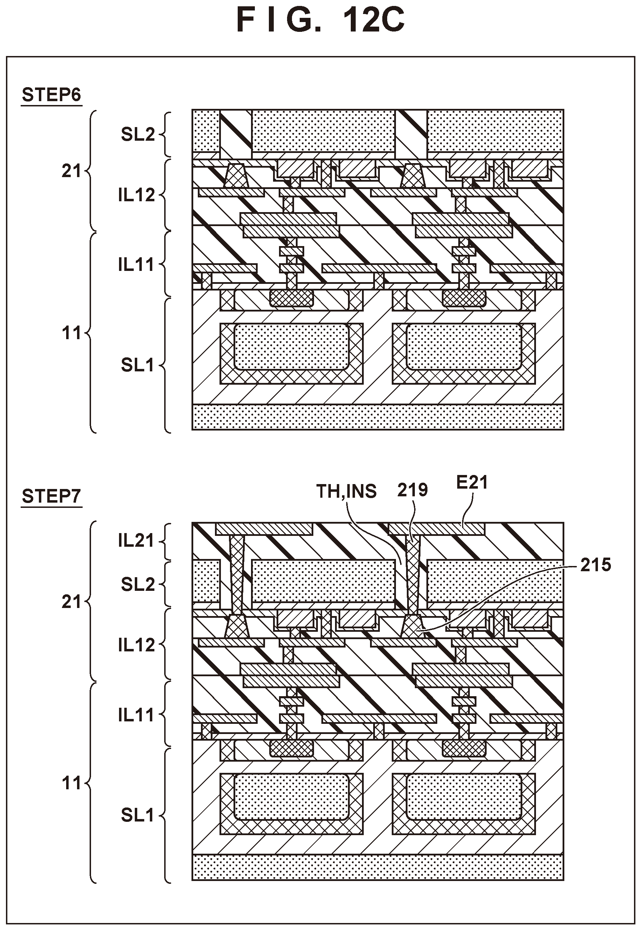

With reference to Figs. 12A, 12B, and 12C, a manufacturing method of the photoelectric conversion device 100 according to the first embodiment will be exemplarily described below. First, in STEP 1, a groove to form the through hole TH is formed in the second semiconductor layer SL2 (more precisely, the second semiconductor substrate for forming the second semiconductor layer SL2), and the insulator INS can be formed in the groove. In STEP 1, for example, transistors can also be formed. Note that the through hole TH and the insulator INS may be formed after the sensor substrate 11 and the first circuit substrate 21 are joined, that is, in STEP 6 to be described later.

In STEP 2, the first film 218 and the second film 216 can sequentially be formed on the second semiconductor layer SL2. The first film 218 can be, for example, a silicon nitride film. The second film 216 can be, for example, a silicon oxide film.

In STEP 3, by etching the second film 216 while using the first film 218 as an etching stopper film, the second opening OP2 is formed, and the connecting member 215 is formed in the second opening OP2. The connecting member 215 can be formed of, for example, tungsten, but may be formed of another material such as aluminum or copper.

In STEP 4, a wiring structure including a wiring layer is further formed on the connecting member 215. With this, the first circuit substrate 21 can be formed. In STEP 5, the sensor substrate 11 (first substrate), which is prepared in a step of preparing the sensor substrate 11 (first substrate) (not shown), and the first circuit substrate 21 (second substrate) formed through STEP 1 to STEP 4 can be joined. At this time, the junction electrode E11 and the junction electrode E12 can be joined.

In STEP 6, the second semiconductor layer SL2 can be formed by thinning the second semiconductor substrate, as needed. In STEP 7, the insulating layer IL21 can be formed. Furthermore, a through hole can be formed in the insulating layer IL21 and the second semiconductor layer SL2 so as to extend through the insulator INS in the through hole TH, and the through via 219 can be formed by filling the through hole with a conductive material. With this, the through via 219 extending through the second semiconductor layer SL2 and reaching the connecting member 215 is formed. The through via 219 can be formed of, for example, tungsten, but may be formed of another material such as aluminum or copper. The through hole for forming the through via 219 can be formed by etching the insulating layer IL21 and the second semiconductor layer SL2 while using the connecting member 215 as an etching stop. In a case of forming the photoelectric conversion device 100 schematically shown in Fig. 10, the through via 219 is formed in the first circuit substrate 21 (second substrate), and then the sensor substrate 11 and the first circuit substrate 21 can be joined.

By joining the second circuit substrate 31 to the first circuit substrate 21, the photoelectric conversion device 100 having the structure schematically shown in Fig. 7 can be obtained.

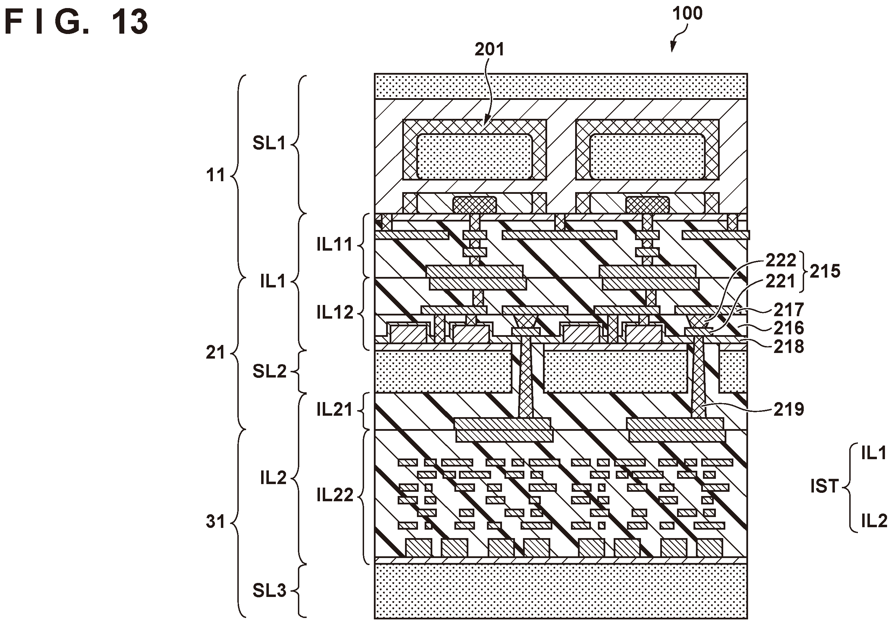

Fig. 13 schematically shows the sectional structure of the photoelectric conversion device 100 as the semiconductor device according to the second modification. Matters not mentioned with respect to the second modification can follow the first embodiment or the first modification, unless they contradict each other. In the second modification, the connecting member 215 can include a conductive pattern 221 arranged to electrically contact the through via 219, and a plug 222 electrically connecting the conductive pattern 221 and the wiring pattern 217. The conductive pattern 221 can be formed of, for example, aluminum or tungsten.

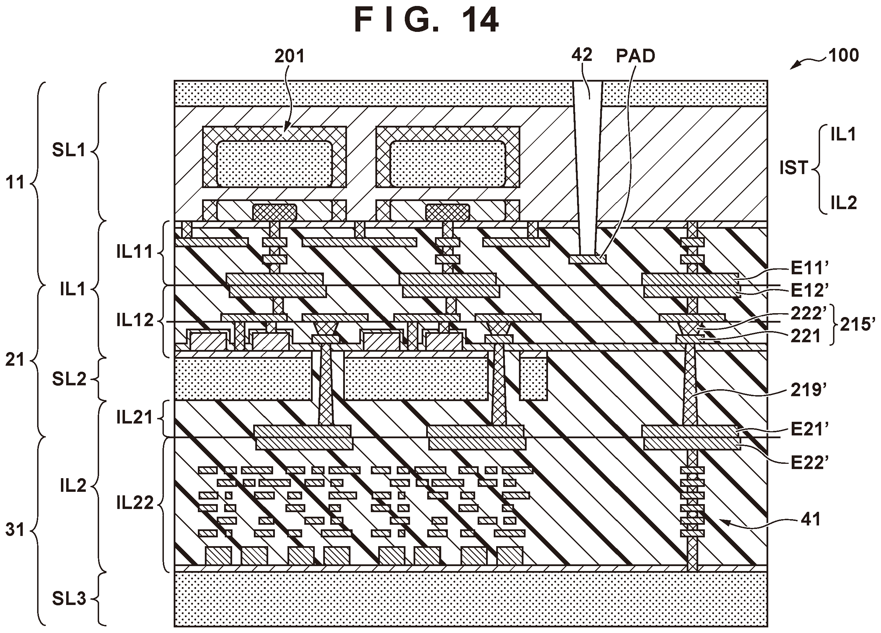

Fig. 14 is a schematic sectional view showing the arrangement of the photoelectric conversion device 100 according to the second modification. Fig. 14 corresponds to a schematic sectional view taken along a line B - B' in Fig. 11A. The photoelectric conversion device 100 can include the guard ring 41 arranged between the pixel array region 12 and the edge EP. The guard ring 41 can include the through via 219' and the connecting member 215' that can have a sectional structure similar to that of the through via 219 and the connecting member 215. The connecting member 215' can include a conductive pattern 221' and a plug 222' that can have sectional structures similar to those of the conductive pattern 221 and the plug 222, respectively. The guard ring 41 can also include the junction portions E11', E12', 21', and E21' that can have a sectional structure similar to that of the junction electrodes E11, E12, 21, and E21. The photoelectric conversion device 100 can include the pad PAD arranged between the guard ring 41 and the pixel array region 12, and the pad opening 42 for exposing the pad PAD.

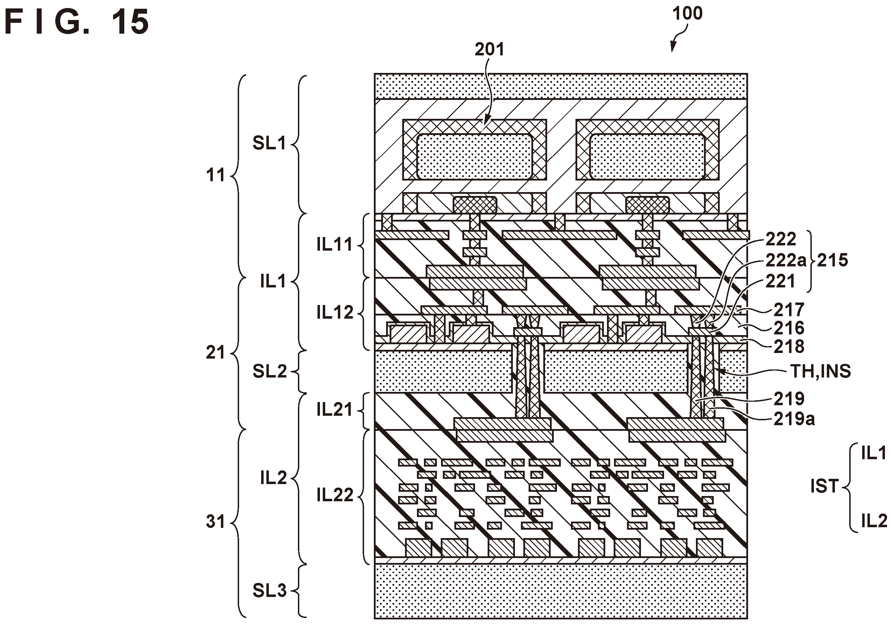

Fig. 15 schematically shows the sectional structure of the photoelectric conversion device 100 as the semiconductor device according to the third modification. Matters not mentioned with respect to the third modification can follow the first embodiment, the first modification, or the second modification, unless they contradict each other. In the third modification, a second through via 219a extending through the insulator INS arranged in the through hole TH is provided in parallel with the through via 219. In the third modification, a conductive plug 222a (second connecting member) arranged in the insulating structure INS (first insulating layer IL1) so as to electrically connect the second through via 219a and the wiring pattern 217 may be provided in parallel with the plug 222 (connecting member). The conductive pattern 221 as a part of the connecting member may be shared by the through via 219 and the second through via 219a, but may be provided individually. From another viewpoint, the conductive pattern 221 as a part of the connecting member may be shared by the through via 219 and the second through via 219a, but may be provided individually. This arrangement is advantageous in improving yield or the like.

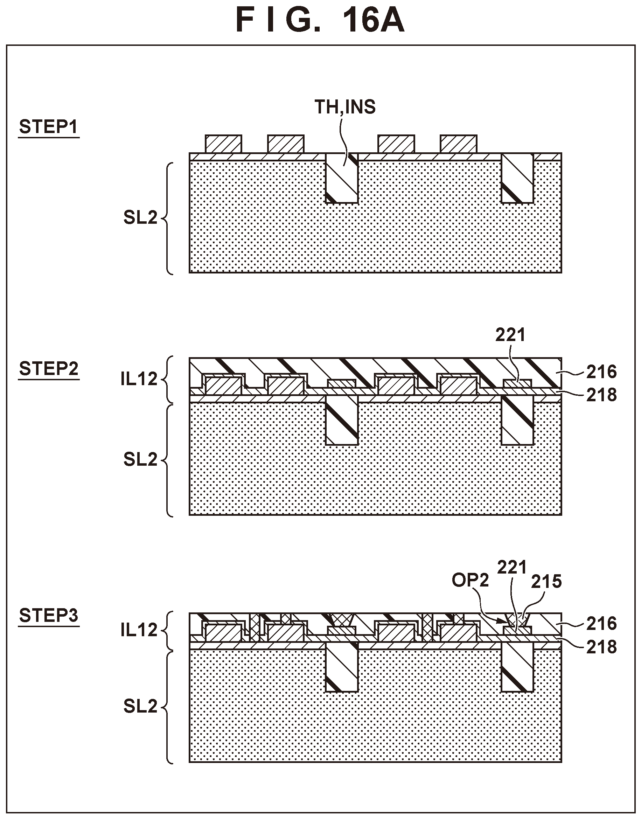

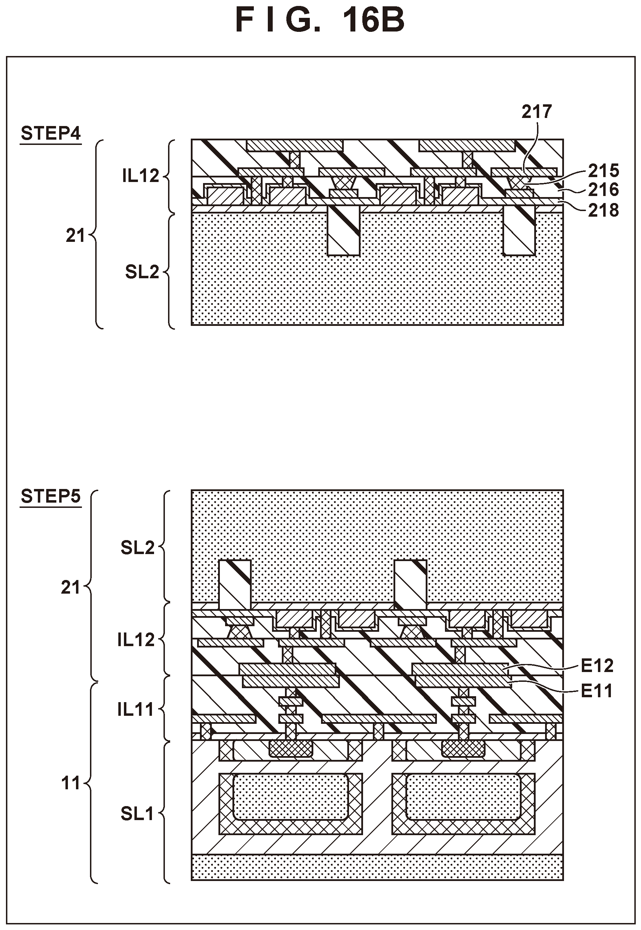

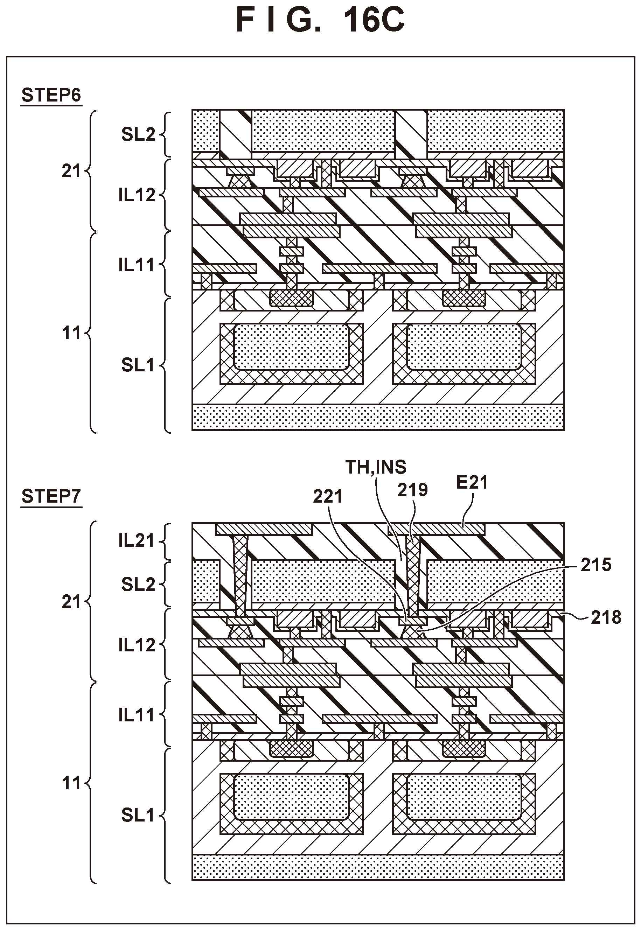

With reference to Figs. 16A, 16B, and 16C, a manufacturing method of the photoelectric conversion device 100 according to the second modification schematically shown in Fig. 13 will be exemplarily described below. First, in STEP 1, a groove to form the through hole TH is formed in the second semiconductor layer SL2 (more precisely, the second semiconductor substrate for forming the second semiconductor layer SL2), and the insulator INS is formed in the groove. In STEP 1, for example, transistors can also be formed. Note that the through hole TH and the insulator INS may be formed after the sensor substrate 11 and the first circuit substrate 21 are joined, that is, in STEP 6 to be described later.

In STEP 2, the first film 218 can be formed on the second semiconductor layer SL2, the conductive pattern 221 can be formed on the first film 218, and the second film 216 can be formed on the conductive pattern 221. The first film 218 can be, for example, a silicon nitride film. The conductive pattern 221 can be formed of, for example, aluminum or tungsten. The second film 216 can be, for example, a silicon oxide film.

In STEP 3, by etching the second film 216 while using the conductive pattern 221 as an etching stopper film, the second opening OP2 is formed, and the connecting member 215 is formed in the second opening OP2. The connecting member 215 can be formed of, for example, tungsten, but may be formed of another material such as aluminum or copper.

In STEP 4, a wiring structure including a wiring layer is further formed on the connecting member 215. With this, the first circuit substrate 21 can be formed. In STEP 5, the sensor substrate 11 (first substrate), which is prepared in a step of preparing the sensor substrate 11 (first substrate) (not shown), and the first circuit substrate 21 (second substrate) formed through STEP 1 to STEP 4 can be joined. At this time, the junction electrode E11 and the junction electrode E12 can be joined.

In STEP 6, the second semiconductor layer SL2 can be formed by thinning the second semiconductor substrate, as needed. In STEP 7, the insulating layer IL21 can be formed. Furthermore, a through hole can be formed in the insulating layer IL21, the second semiconductor layer SL2, and the first film 218 so as to extend through the insulator INS in the through hole TH and the first film 218. The through via 219 can be formed by filling the through hole with a conductive material. With this, the through via 219 extending through the second semiconductor layer SL2 and the first film 216 and reaching the conductive pattern 221 is formed. The through via 219 can be formed of, for example, tungsten, but may be formed of another material such as aluminum or copper. The through hole for forming the through via 219 can be formed by etching the insulating layer IL21, the second semiconductor layer SL2, and the second film 218 while using the conductive pattern 221 as an etching stop.

Application example of the above-described photoelectric conversion device 100 will be described below as the second to eighth embodiments.

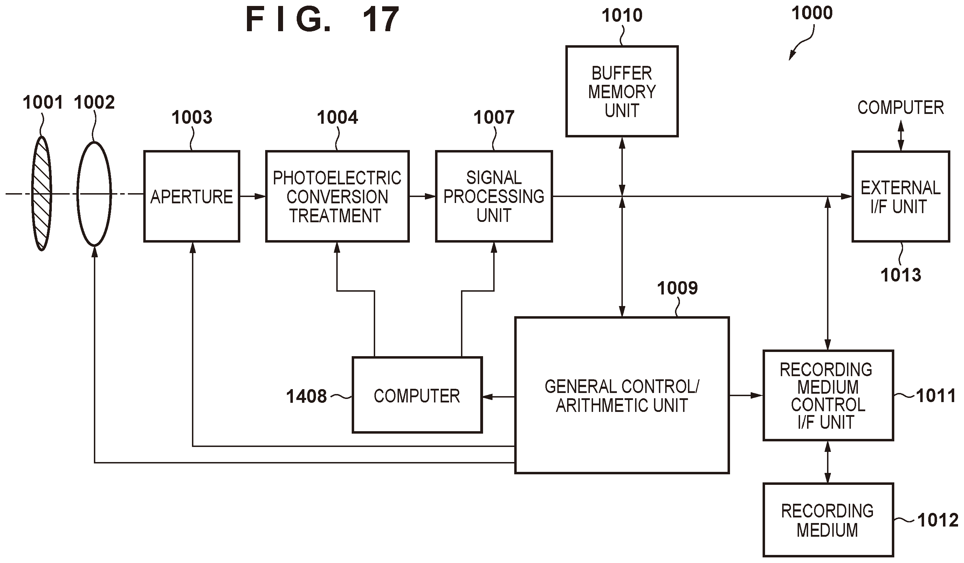

A photoelectric conversion system according to the second embodiment will be described with reference to Fig. 17. Fig. 17 is a block diagram showing the schematic arrangement of the photoelectric conversion system according to the second embodiment.

The above-described photoelectric conversion device 100 is applicable to various kinds of photoelectric conversion systems. Examples of photoelectric conversion systems to which the photoelectric conversion device is applicable are a digital still camera, a digital camcorder, a monitoring camera, a copying machine, a facsimile apparatus, a mobile phone, an in-vehicle camera, and an observation satellite. A camera module including an optical system such as a lens and an image capturing device is also included in the photoelectric conversion systems. Fig. 7 exemplarily shows the block diagram of a digital still camera as an example of these.

A photoelectric conversion system 1000 exemplarily shown in Fig. 17 includes an image capturing device 1004 as an example of the photoelectric conversion device. The photoelectric conversion system 1000 also includes a lens 1002 that forms an optical image of an object on the image capturing device 1004, an aperture 1003 configured to change the amount of light passing through the lens 1002, and a barrier 1001 configured to protect the lens 1002. The lens 1002 and the aperture 1003 form an optical system (optical device) that condenses light to the image capturing device 1004. The image capturing device 1004 is the photoelectric conversion device 100 (image capturing device) described above, and converts the optical image formed by the lens 1002 into an electrical signal.

The photoelectric conversion system 1000 also includes a signal processing unit 1007 that is an image generation unit configured to generate an image by processing an output signal output from the image capturing device 1004. The signal processing unit 1007 functions as a processing device that performs an operation of performing various kinds of correction and compression as needed, thereby outputting image data. The signal processing unit 1007 may be formed on a semiconductor substrate on which the image capturing device 1004 is provided or may be formed on a semiconductor substrate different from the image capturing device 1004. In addition, the image capturing device 1004 and the signal processing unit 1007 may be formed on the same semiconductor substrate.

The photoelectric conversion system 1000 further includes a memory unit 1010 configured to temporarily store image data, and an external interface unit (external I/F unit) 1013 configured to communicate with an external computer or the like. Furthermore, the photoelectric conversion system 1000 includes a recording medium 1012 such as a semiconductor memory configured to record or read out image capturing data, and a recording medium control interface unit (recording medium control I/F unit) 1011 configured to perform record or readout for the recording medium 1012. The recording medium control I/F unit 1011 and the recording medium 1012 can form a part of a recording device. Note that the recording medium 1012 may be incorporated in the photoelectric conversion system 1000 or may be detachable.

Furthermore, the photoelectric conversion system 1000 includes a general control/arithmetic unit 1009 that controls various kinds of operations and the entire digital still camera, and a timing generation unit 1008 that outputs various kinds of timing signals to the image capturing device 1004 and the signal processing unit 1007. The general control/arithmetic unit 1009 and the timing generation unit 1008 can form a part of a control device configured to control an operation of the photoelectric conversion system 1000. In this example, the timing signal and the like may be input from the outside, and the photoelectric conversion system 1000 need only include at least the image capturing device 1004, and the signal processing unit 1007 that processes an output signal output from the image capturing device 1004.

The image capturing device 1004 outputs an image capturing signal to the signal processing unit 1007. The signal processing unit 1007 executes predetermined signal processing for the image capturing signal output from the image capturing device 1004, and outputs image data. The signal processing unit 1007 generates an image using the image capturing signal. Although not shown in Fig. 17, a display device such as a display for displaying the generated image may be arranged in the photoelectric conversion system 1000. As described above, according to this embodiment, it is possible to implement the photoelectric conversion system 1000 to which the photoelectric conversion device 100 (image capturing device) according to one of the above-described embodiments is applied.

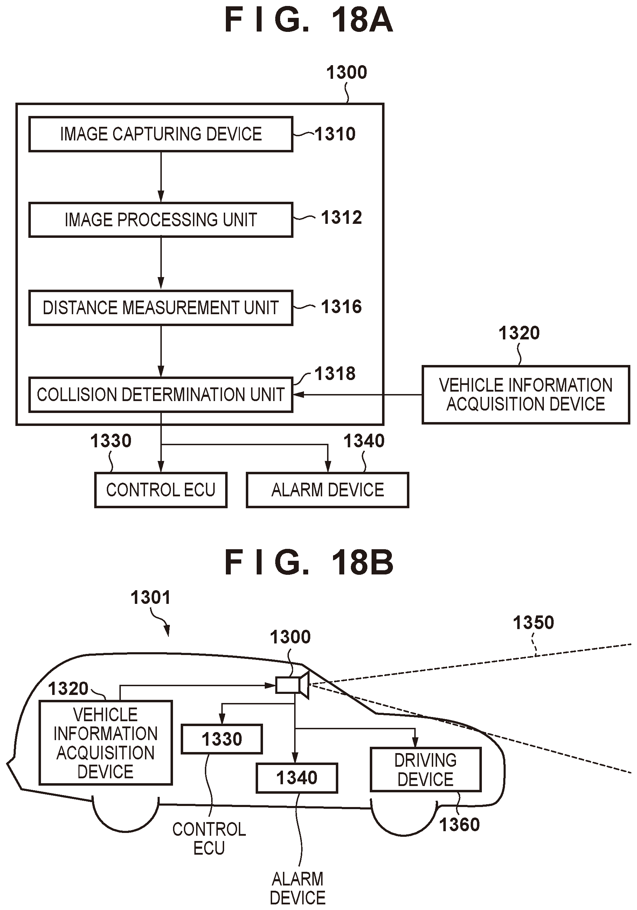

A photoelectric conversion system 1300 and a moving body 1301 according to the third embodiment will be described with reference to Figs. 18A and 18B. Figs. 18A and 18B are views showing the arrangement of the photoelectric conversion system 1300 and the moving body 1301 according to the third embodiment.

Fig. 18A shows an example of a photoelectric conversion system concerning an in-vehicle camera. The photoelectric conversion system 1300 includes an image capturing device 1310. The image capturing device 1310 is the photoelectric conversion device 100 (image capturing device) described above. The photoelectric conversion system 1300 includes an image processing unit 1312 that performs image processing for a plurality of image data acquired by the image capturing device 1310. The photoelectric conversion system 1300 also includes a distance acquisition unit 1316 that calculates the distance up to a target object, and a collision determination unit 1318 that determines, based on the calculated distance, whether there is collision possibility. Here, the distance acquisition unit 1316 may acquire distance information up to a target object by using Time of Flight (ToF) method, or may acquire distance information by using parallax information or the like. That is, the distance information is information concerning a parallax, a defocus amount, a distance up to a target object, and the like. The collision determination unit 1318 may determine collision possibility using one of the pieces of distance information. The distance acquisition unit 1316 may be implemented by exclusively designed hardware, or may be implemented by a software module. The distance acquisition unit 1316 may be implemented by a Field Programmable Gate Array (FPGA), Application Specific Integrated Circuit (ASIC), or the like. Alternatively, the distance acquisition unit 1316 may be implemented by a combination of these.

The photoelectric conversion system 1300 is connected to a vehicle information acquisition device 1320, and can acquire vehicle information such as a vehicle speed, a yaw rate, and a steering angle. The photoelectric conversion system 1300 is also connected to an ECU 1330 that is a control device configured to output a control signal for generating a braking force to the vehicle based on the determination result of the collision determination unit 1318. Furthermore, the photoelectric conversion system 1300 is connected to an alarm device 1340 that generates an alarm to the driver based on the determination result of the collision determination unit 1318. For example, if collision possibility is high as the determination result of the collision determination unit 1318, the ECU 1330 controls a driving device (machine device) 1360 to perform braking, releasing the accelerator pedal, or suppressing the engine output, thereby controlling the vehicle for avoiding collision and reducing damage. The alarm device 1340 sounds an alarm, displays alarm information on the screen of a car navigation system or the like, or applies a vibration to the seat belt or a steering wheel, thereby making an alarm to the user.

In this embodiment, the periphery of the vehicle (moving body 1301), for example, the front or rear side is captured by the photoelectric conversion system 1300. Fig. 18B shows the photoelectric conversion system when capturing the front side (image capturing range 1350) of the vehicle. The vehicle information acquisition device 1320 sends an instruction to the photoelectric conversion system 1300 or the image capturing device 1310. With this configuration, it is possible to further improve the accuracy of distance measurement.

An example in which control is executed so as not to collide with another vehicle has been explained above. The photoelectric conversion system 1300 can also be applied to control of performing automated driving following another vehicle or control of performing automated driving without deviating from a lane. Furthermore, the photoelectric conversion system 1300 can be applied not only to a vehicle such as an automobile but also to, for example, a moving body (moving apparatus) such as a ship, an airplane, or an industrial robot. The moving body includes one or both of a driving force generation unit that generates a driving force mainly used for moving the moving body and a rotating body mainly used for moving the moving body. The driving force generation unit can be an engine, a motor, or the like. The rotating body can be a tire, a wheel, a ship screw, an aircraft propeller, or the like. In addition, the photoelectric conversion system can be applied not only to a moving body but also to equipment that broadly uses object recognition, such as an intelligent transport system (ITS).

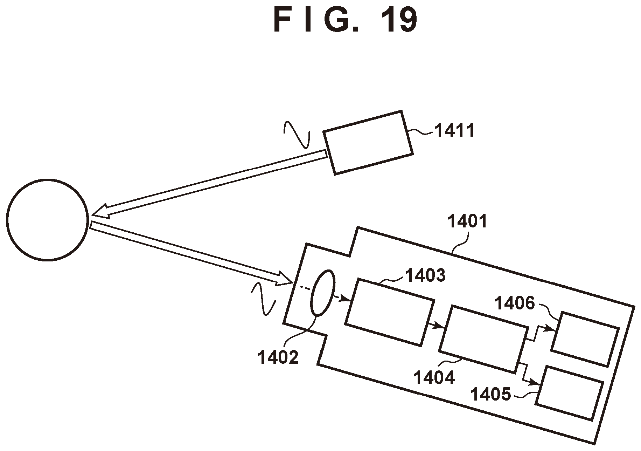

A photoelectric conversion system according to the fourth embodiment will be described with reference to Fig. 19. Fig. 19 is a block diagram showing an example of the arrangement of a distance image sensor 1401 as the photoelectric conversion system according to this embodiment.

As shown in Fig. 19, the distance image sensor 1401 includes an optical system 1407, a photoelectric conversion device 1408, an image processing circuit 1404, a monitor 1405, and a memory 1406. Then, the distance image sensor 1401 can receive light (modulated light or pulsed light) projected from a light source device 1409 toward an object and reflected by the surface of the object, thereby acquiring a distance image corresponding to the distance up to the object.

The optical system 1407 is formed by including one or a plurality of lenses, and guides image light (incident light) from the object to the photoelectric conversion device 1408 and forms an image on the light-receiving surface (sensor portion) of the photoelectric conversion device 1408.

As the photoelectric conversion device 1408, the photoelectric conversion device 100 described above is applied, and a distance signal indicating a distance obtained from a light reception signal output from the photoelectric conversion device 1408 is supplied to the image processing circuit 1404.

The image processing circuit 1404 performs image processing of creating a distance image based on the distance signal supplied from the photoelectric conversion device 1408. Then, the distance image (image data) obtained by the image processing is supplied to and displayed on the monitor 1405, and supplied to and stored (recorded) in the memory 1406.

The distance image sensor 1401 having such arrangement can acquire, for example, a more correct distance image along with improvement in characteristic of pixels by applying the above-described photoelectric conversion device 100.

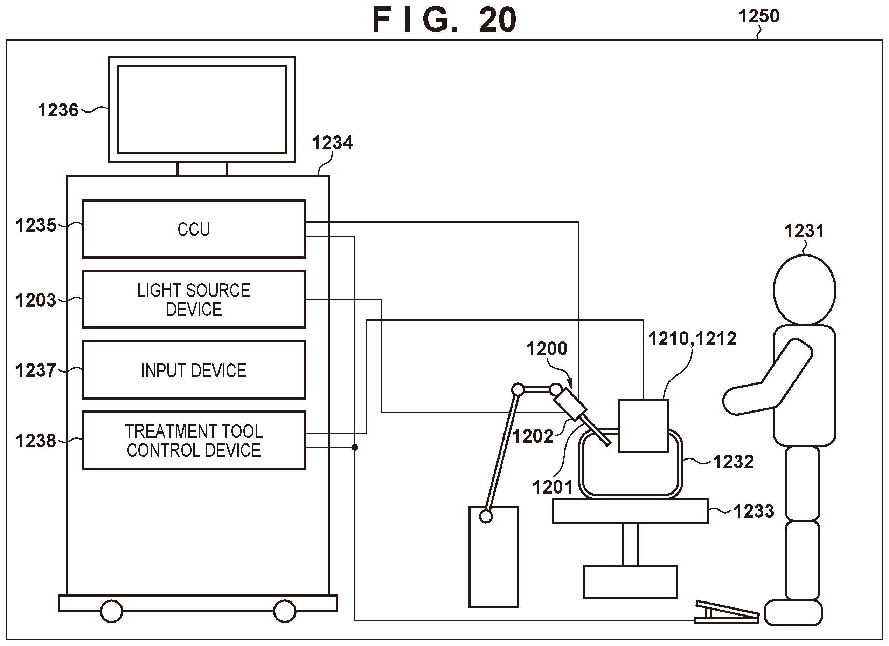

A photoelectric conversion system according to the fifth embodiment will be described with reference to Fig. 20. Fig. 20 is a view showing an example of the schematic arrangement of an endoscopic surgery system 1250 as the photoelectric conversion system according to this embodiment.

Fig. 20 shows a state in which an operator (doctor) 1231 operates on a patient 1232 on a patient bed 1233 using the endoscopic surgery system 1250. As shown in Fig. 20, the endoscopic surgery system 1250 is formed from an endoscope 1200, a surgical tool 1210, and a cart 1234 on which various devices for endoscopic surgery are mounted.

The endoscope 1200 includes a lens barrel 1201 including a region of a predetermined length from the distal end, which is inserted into the body cavity of the patient 1232, and a camera head 1202 connected to the proximal end of the lens barrel 1201. In the example shown in Fig. 20, the endoscope 1200 formed as a so-called hard mirror including the hard lens barrel 1201 is shown but the endoscope 1200 may be formed as a so-called soft mirror including a soft lens barrel.

An opening in which an objective lens is fitted is provided at the distal end of the lens barrel 1201. A light source device 1203 is connected to the endoscope 1200, and light generated by the light source device 1203 is guided to the distal end of the lens barrel by a light guide extended inside the lens barrel 1201, and is emitted to an observation target in the body cavity of the patient 1232 via the objective lens. Note that the endoscope 1200 may be a forward-viewing endoscope or may be a forward-oblique viewing endoscope or side-viewing endoscope.

An optical system and a photoelectric conversion device are provided in the camera head 1202, and reflected light (observation light) from the observation target is condensed by the optical system to the photoelectric conversion device. The observation light is photoelectrically converted by the photoelectric conversion device to generate an electrical signal corresponding to the observation light, that is, an image signal corresponding to an observation image. As the photoelectric conversion device, the photoelectric conversion device 100 (image capturing device) described in each of the above-described embodiments can be used. The image signal is transmitted as RAW data to a Camera Control Unit (CCU) 1235.

The CCU 1235 is formed by a Central Processing Unit (CPU), a Graphics Processing Unit (GPU), and the like, and comprehensively controls the operations of the endoscope 1200 and a display device 1236. Furthermore, the CCU 1235 receives an image signal from the camera head 1202, and performs, for the image signal, various kinds of image processes such as development processing (demosaic processing) for displaying an image based on the image signal.

Under the control of the CCU 1235, the display device 1236 displays the image based on the image signal having undergone the image processing by the CCU 1235.

The light source device 1203 is formed from a light source such as a Light Emitting Diode (LED), and supplies, to the endoscope 1200, irradiation light at the time of imaging an operation site or the like.

An input device 1237 is an input interface to the endoscopic surgery system 1250. The user can input various kinds of information or instructions to the endoscopic surgery system 1250 via the input device 1237.

A treatment tool control device 1238 controls driving of an energy treatment tool 1212 for ablation or incision of the tissue, sealing of a blood vessel, or the like.

The light source device 1203 that supplies, to the endoscope 1200, irradiation light at the time of imaging an operation site can be formed from, for example, a white light source formed by an LED, a laser light source, or a combination thereof. If the white light source is formed by a combination of RGB laser light sources, it is possible to accurately control the output intensity and output timing of each color (each wavelength), and thus the light source device 1203 can adjust the white balance of a captured image. In this case, the observation target is time-divisionally irradiated with laser beams from the RGB laser light sources, respectively, and driving of the image sensor of the camera head 1202 is controlled in synchronism with the irradiation timings, thereby making it possible to time-divisionally capture images respectively corresponding to R, G, and B. In this method, it is possible to obtain a color image without providing color filters in the image sensor.

Driving of the light source device 1203 may be controlled to change the intensity of light to be output for every predetermined time. It is possible to time-divisionally acquire images by controlling driving of the image sensor of the camera head 1202 in synchronism with the timing of changing the intensity of the light, and combine the images, thereby generating an image of a high dynamic range without so-called shadow detail loss or highlight detail loss.

The light source device 1203 may be configured to supply light in a predetermined wavelength band corresponding to special light observation. In special light observation, for example, the wavelength dependency of light absorption in the body tissue is used. More specifically, by performing irradiation with light in a narrow band, as compared with irradiation light (that is, white light) at the time of normal observation, predetermined tissue such as a blood vessel in the mucous membrane surface layer is captured with high contrast. Alternatively, in special light observation, fluorescence observation for obtaining an image by using fluorescence generated by irradiating with excitation light may be performed. In fluorescence observation, it is possible to, for example, irradiate body tissue with excitation light and observe fluorescence from the body tissue, or locally inject a reagent such as indocyanine green (ICG) to body tissue while irradiating the body tissue with excitation light corresponding to the fluorescence wavelength of the reagent, thereby obtaining a fluorescence image. The light source device 1203 can be configured to supply narrow band light and/or excitation light corresponding to such special light observation.

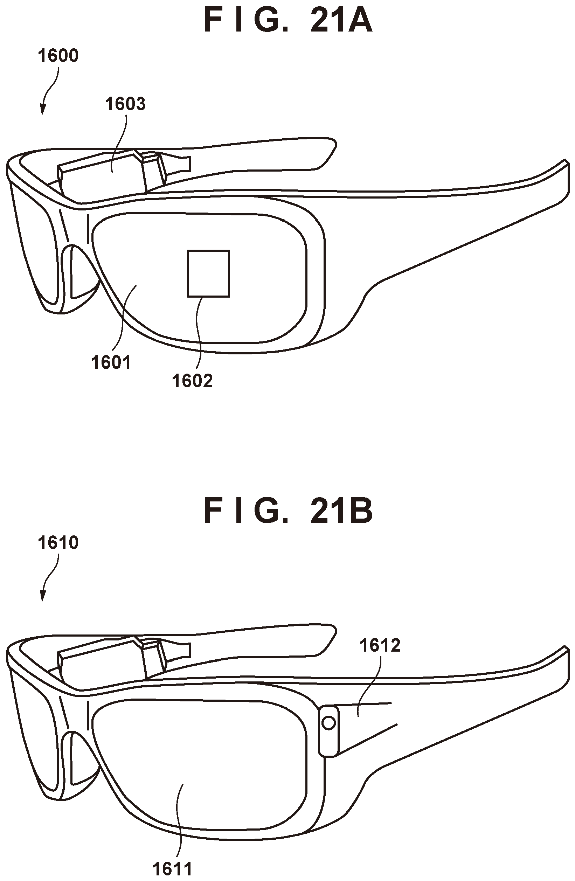

A photoelectric conversion system according to the sixth embodiment will be described with reference to Figs. 21A and 21B. Fig. 21A describes glasses 1600 (smartglasses) as the photoelectric conversion system according to this embodiment. The glasses 1600 include a photoelectric conversion device 1602. The photoelectric conversion device 1602 is the photoelectric conversion device 100 (image capturing device) described in each of the above embodiments. A display device including the light emitting device such as an OLED or LED may be provided on the back surface side of a lens 1601. One or a plurality of photoelectric conversion devices 1602 may be provided. Alternatively, a plurality of kinds of photoelectric conversion devices may be used in combination. The arrangement position of the photoelectric conversion device 1602 is not limited to that shown in Fig. 21A.

The glasses 1600 further include a control device 1603. The control device 1603 functions as a power supply that supplies electric power to the photoelectric conversion device 1602 and the above-described display device. In addition, the control device 1603 controls the operations of the photoelectric conversion device 1602 and the display device. An optical system configured to condense light to the photoelectric conversion device 1602 is formed on the lens 1601.

Fig. 21B describes glasses 1610 (smartglasses) according to an application example. The glasses 1610 include a control device 1612, and a photoelectric conversion device corresponding to the photoelectric conversion device 1602 and a display device are mounted on the control device 1612. The photoelectric conversion device in the control device 1612 and an optical system configured to project light emitted from the display device are formed in a lens 1611, and an image is projected to the lens 1611. The control device 1612 functions as a power supply that supplies electric power to the photoelectric conversion device and the display device, and controls the operations of the photoelectric conversion device and the display device. The control device may include a line-of-sight detection unit that detects the line of sight of a wearer. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in a plan view is provided, thereby reducing deterioration of image quality.

The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The display device according to the embodiment can include a photoelectric conversion device including a light receiving element, and control a displayed image of the display device based on the line-of-sight information of the user from the photoelectric conversion device.

More specifically, the display device decides a first visual field region at which the user is gazing and a second visual field region other than the first visual field region based on the line-of-sight information. The first visual field region and the second visual field region may be decided by the control device of the display device, or those decided by an external control device may be received. In the display region of the display device, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority may be decided from the first display region and the second display region based on line-of-sight information. The first visual field region and the second visual field region may be decided by the control device of the display device, or those decided by an external control device may be received. The resolution of the region of higher priority may be controlled to be higher than the resolution of the region other than the region of higher priority. That is, the resolution of the region of relatively low priority may be low.

Note that AI may be used to decide the first visual field region or the region of higher priority. The AI may be a model configured to estimate the angle of the line of sight and the distance to a target object ahead the line of sight from the image of the eyeball using the image of the eyeball and the direction of actual viewing of the eyeball in the image as supervised data. The AI program may be held by the display device, the photoelectric conversion device, or an external device. If the external device holds the Al program, it is transmitted to the display device via communication.

When performing display control based on line-of-sight detection, smartglasses further including a photoelectric conversion device configured to capture the image of the outside can preferably be applied. The smartglasses can display the captured outside image information in real time.

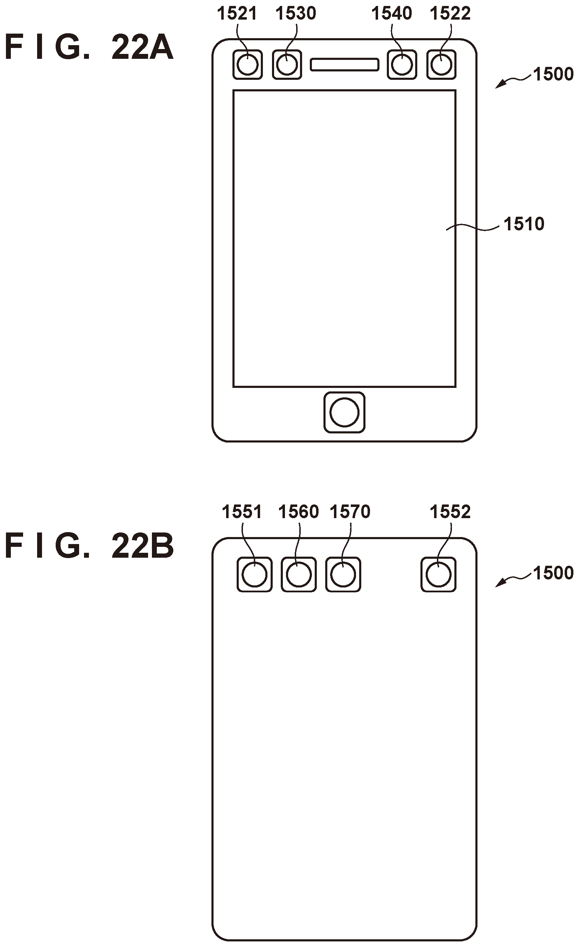

The seventh embodiment will be described with reference to Figs. 22A and 22B. The above-described photoelectric conversion device and photoelectric conversion system may be applied to, for example, electronic equipment such as a so-called smartphone or tablet.

Figs. 22A and 22B are views showing an example of electronic equipment 1500 on which the photoelectric conversion device is mounted. Fig. 22A shows the front surface side of the electronic equipment 1500, and Fig. 22B shows the back surface side of the electronic equipment 1500.

As shown in Fig. 22A, a display 1510 that displays an image is arranged at the center of the front surface of the electronic equipment 1500. Then, front cameras 1521 and 1522 for each of which the above-described photoelectric conversion device 100 is used, an IR light source 1530 that emits infrared rays, and a visible light source 1540 that emits visible light are arranged along the upper side of the front surface of the electronic equipment 1500.

As shown in Fig. 22B, rear cameras 1551 and 1552 for each of which the above-described photoelectric conversion device 100 is used, an IR light source 1560 that emits infrared rays, and a visible light source 1570 that emits visible light are arranged along the upper side of the back surface of the electronic equipment 1500.

By applying the above-described photoelectric conversion device 100, the electronic equipment 1500 having the above arrangement can capture, for example, an image of higher quality. Note that the photoelectric conversion device can be applied to electronic equipment such as an infrared sensor, a distance measurement sensor using an active infrared source, a security camera, or a personal or biometric authentication camera. This can improve the accuracy and performance of the electronic equipment.

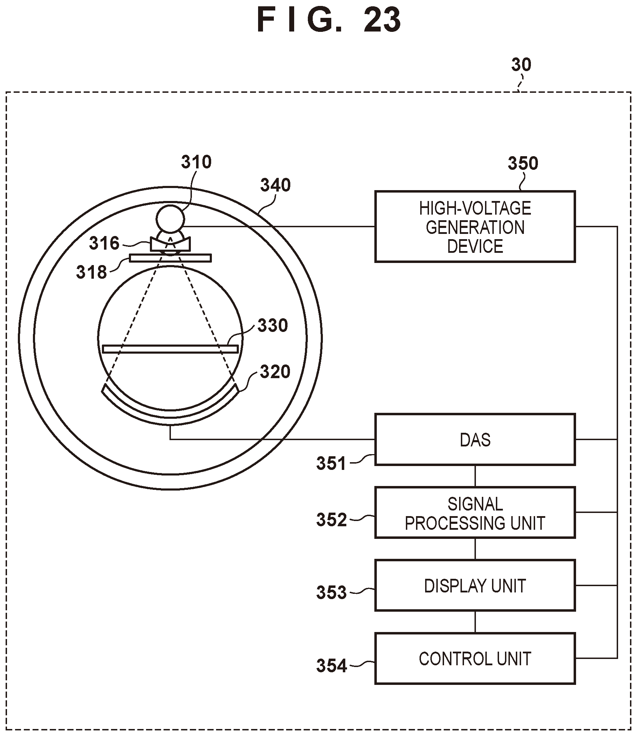

Fig. 23 is a block diagram of an X-ray CT apparatus according to eighth embodiment. The above-described photoelectric conversion device 100 is applicable to a detector of the X-ray CT apparatus. An X-ray CT apparatus 30 according to this embodiment includes an X-ray generation unit 310, a wedge 316, a collimator 318, an X-ray detection unit 320, a top plate 330, a rotating frame 340, and a high-voltage generation device 350. The X-ray CT apparatus 30 also includes a Data Acquisition System (DAS) 351, a signal processing unit 352, a display unit 353, and a control unit 354.

The X-ray generation unit 310 is formed from, for example, a vacuum tube that generates X-rays. The vacuum tube of the X-ray generation unit 310 is supplied with a filament current and a high voltage from the high-voltage generation device 350. When thermoelectrons are emitted from a cathode (filament) to an anode (target), X-rays are generated.

The wedge 316 is a filter that adjusts the amount of X-rays emitted from the X-ray generation unit 310. The wedge 316 attenuates the amount of X-rays so that the X-rays emitted from the X-ray generation unit 310 to an object have a predetermined distribution. The collimator 318 is formed from a lead plate that narrows the irradiation range of the X-rays having passed through the wedge 316. The X-rays generated by the X-ray generation unit 310 are formed in a cone beam shape via the collimator 318, and the object on the top plate 330 is irradiated with the X-rays.

The X-ray detection unit 320 is formed using the above-described photoelectric conversion device 100. The X-ray detection unit 320 detects the X-rays having passed through the object from the X-ray generation unit 310, and outputs a signal corresponding to the amount of the X-rays to the DAS 351.

The rotating frame 340 is annular, and is configured to be rotatable. The X-ray generation unit 310 (the wedge 316 and the collimator 318) and the X-ray detection unit 320 are arranged to face each other in the rotating frame 340. The X-ray generation unit 310 and the X-ray detection unit 320 can rotate together with the rotating frame 340.

The high-voltage generation device 350 includes a boosting circuit, and outputs a high voltage to the X-ray generation unit 310. The DAS 351 includes an amplification circuit and an A/D conversion circuit, and outputs, as digital data, a signal from the X-ray detection unit 320 to the signal processing unit 352.

The signal processing unit 352 includes a Central Processing Unit (CPU), a Read Only Memory (ROM), and a Random Access Memory (RAM), and can execute image processing and the like for the digital data. The display unit 353 includes a flat display device or the like, and can display an X-ray image. The control unit 354 includes a CPU, a ROM, a RAM, and the like, and controls the operation of the overall X-ray CT apparatus 30.

The above-described embodiments can be changed appropriately without departing from the technical concept. Note that contents disclosed in this specification include not only contents described in this specification but also all items that can be grasped from this specification and its accompanying drawings. The contents disclosed in this specification include a complementary set of concepts described in this specification. That is, if, for example, "A is larger than B" is described in this specification, this specification is considered to disclose "A is not larger than B" even if a description of "A is not larger than B" is omitted. This is because if "A is larger than B" is described, it is assumed that a case in which "A is not larger than B" has been considered.

This application claims priority from Japanese Patent Application No. 2023-204913 filed December 4, 2023, which is hereby incorporated by reference herein.

The present invention is not limited to the above embodiments and various changes and modifications can be made within the spirit and scope of the present invention. Therefore, to apprise the public of the scope of the present invention, the following claims are made.

### REFERENCE SIGNS LIST

100: photoelectric conversion device (semiconductor device), SL1: first semiconductor layer, SL2: second semiconductor layer, IST: insulating structure, IL1: first insulating layer, IL2: second insulating layer, 215: connecting member, 217: wiring pattern, 219; through via

## Claims

1. A semiconductor device that has a structure in which a plurality of semiconductor layers including a first semiconductor layer, a second semiconductor layer, and a third semiconductor layer and an insulating structure insulating the plurality of semiconductor layers from each other are stacked, the insulating structure including a first insulating layer arranged between the first semiconductor layer and the second semiconductor layer, and the second insulating layer between the second semiconductor layer and the third semiconductor layer, comprising:
a conductive through via extending through the second semiconductor layer;
a wiring pattern arranged in the first insulating layer; and
a conductive connecting member arranged in the first insulating layer to electrically connect the through via and the wiring pattern.

2. The semiconductor device according to claim 1, wherein
the connecting member contains tungsten, and the wiring pattern contains copper.

3. The semiconductor device according to claim 1 or 2, wherein
the connecting member includes a conductive pattern arranged to electrically contact the through via, and a plug electrically connecting the conductive pattern and the wiring pattern.

4. The semiconductor device according to any one of claims 1 to 3, wherein
in a connection portion between the through via and the connecting member, a width of the connecting member is larger than a width of the through via.

5. The semiconductor device according to any one of claims 1 to 4, wherein
in a connection portion between the through via and the connecting member, a width of the through via is larger than a width of the connecting member.

6. The semiconductor device according to claim 4, wherein
in a connection portion between the connecting member and the wiring pattern, a width of the wiring pattern is larger than a width of the connecting member.

7. The semiconductor device according to claim 4, wherein
in a connection portion between the connecting member and the wiring pattern, a width of the connecting member is larger than a width of the wiring pattern.

8. The semiconductor device according to any one of claims 1 to 7, wherein
the insulating structure includes a first film including a first opening, and a second film arranged to overlap the first film and including a second opening, and
the through via includes a portion arranged in the first opening, and the connecting member is arranged in the second opening.

9. The semiconductor device according to any one of claims 1 to 8, wherein
the through via is arranged to extend through an insulator arranged in a through hole in the second semiconductor layer.

10. The semiconductor device according to claim 9, further comprising:
a second through via extending through the insulator; and
a second conductive connecting member arranged in the insulating structure to electrically connect the second through via and the wiring pattern.

11. The semiconductor device according to claim 9, further comprising
a second through via extending through the insulator,
wherein the connecting member is arranged to electrically connect the second through via and the wiring pattern.

12. The semiconductor device according to any one of claims 1 to 10, wherein
the through via has a tapered shape with a width decreasing toward the connecting member.

13. The semiconductor device according to any one of claims 1 to 10, wherein
the connecting member has a tapered shape with a width decreasing toward the through via.

14. The semiconductor device according to any one of claims 1 to 10, wherein
the through via has a tapered shape with a width decreasing toward the connecting member, and
the connecting member has a tapered shape with a width decreasing toward the through via.

15. The semiconductor device according to any one of claims 1 to 14, wherein
a thickness of the second semiconductor layer is smaller than a thickness of each semiconductor layer of the plurality of semiconductor layers other than the second semiconductor layer.

16. The semiconductor device according to any one of claims 1 to 15, wherein
the second insulating layer includes a metal joint surface.

17. A semiconductor device that has a structure in which a plurality of semiconductor layers including a first semiconductor layer and a second semiconductor layer and an insulating structure insulating the plurality of semiconductor layers from each other are stacked, comprising:
a conductive through via extending through the second semiconductor layer;
a wiring pattern arranged in the insulating structure; and
a conductive connecting member arranged in the insulating structure to electrically connect the through via and the wiring pattern,
wherein
the through via has a tapered shape with a width decreasing toward the connecting member, and
the connecting member has a tapered shape with a width decreasing toward the through via.

18. The semiconductor device according to any one of claims 1 to 17, wherein
a photoelectric conversion element is arranged in the first semiconductor layer.

19. A manufacturing method of a semiconductor device, comprising:
a step of preparing a first substrate including a first semiconductor layer;
a step of preparing a second substrate including a second semiconductor layer and an insulating layer, in which a conductive connecting member and a wiring pattern electrically connected to the connecting member are arranged in the insulating layer;
a step of forming, in the second semiconductor layer, a through via extending through the second semiconductor layer and reaching the connecting member; and
a step of joining the first substrate and the insulating layer of the second substrate before or after forming of the through via.

20. A photoelectric conversion system comprising:
a semiconductor device defined in claim 18; and
a signal processing unit configured to process a signal output from the semiconductor device.

21. A moving body that includes a semiconductor device defined in claim 18, comprising
a control unit configured to control movement of the moving body using a signal output from the semiconductor device.
